# EUROPÄISCHE PATENTSCHRIFT

(11) **EP 0 806 081 B1**
(45) Veröffentlichungstag und Bekanntmachung des Hinweises auf die Patenterteilung: **28.02.2001**
(21) Anmeldenummer: 96924780.8
(22) Anmeldetag: 30.07.1996
(51) Int. Cl.: H03G 3/34

(54) **SCHALTUNGSANORDNUNG ZUM KURZZEITIGEN STUMMSCHALTEN DER WIEDERGABE EINES NF-SIGNALS IN EINEM RUNDFUNKEMPFÄNGER**
CIRCUIT FOR BRIEFLY MUTING THE REPRODUCTION OF A LOW-FREQUENCY SIGNAL IN A RADIO RECEIVER
CIRCUIT POUR BLOQUER BRIEVEMENT LA REPRODUCTION D'UN SIGNAL BASSE FREQUENCE DANS UN RECEPTEUR RADIO

(30) Priorität: 29.11.1995 DE 19544438
(43) Veröffentlichungstag der Anmeldung: 12.11.1997
(73) Patentinhaber: ROBERT BOSCH GMBH, 70442 Stuttgart (DE)
(72) Erfinder: WERMUTH, Jürgen, D-31228 Peine (DE)
(86) Internationale Anmeldenummer: DE9601410
(87) Internationale Veröffentlichungsnummer: WO9720387

(56) Entgegenhaltungen:
- GB-A- 2 136 254
- PATENT ABSTRACTS OF JAPAN vol. 010, no. 150 (E-408), 31.Mai 1986 & JP,A,61 010327 (FUJITSU TEN KK), 17.Januar 1986,

## Beschreibung

Gegenstand des Schutzrechts ist eine Schaltungsanordnung zum kurzzeitigen Stummschalten der Wiedergabe eines NF-Signals in einem Rundfunkempfänger nach dem Oberbegriff des Anspruchs 1.

Eine derartige Schaltungsanordnung ist aus der älteren Patentanmeldung P 43 26 097 desselben Erfinders bekannt. Diese bekannte Schaltungsanordnung löst die Aufgabe, extrem kurze, kaum wahrnehmbare, knackgeräuschfreie Unterbrechungen des NF-Signals im Rundfunkempfänger zur Durchführung von zusätzlichen Steuerungen zu ermöglichen.

Der vorliegende nächste Stand der Technik ist in Dokument GB 2 136 254 A beschrieben.

Der vorliegenden Erfindung lag die Aufgabe zugrunde, den Übergang in den stummgeschalteten bzw. wieder eingeschalteten Zustand hinsichtlich der Freiheit von Knackgeräuschen bei einer Unterbrechung und der Vermeidung der Wahrnehmbarkeit der Unterbrechungen selbst weiter zu verbessern.

Diese Aufgabe wird erfindungsgemäß durch die im Anspruch 1 angegebenen Maßnahmen gelöst.

Vorteilhafte Ausgestaltungen der Erfindung sind durch die Merkmale der Unteransprüche gekennzeichnet.

Einzelheiten der Erfindung werden anhand der Zeichnungen erläutert. Dazu zeigen
- Fig. 1: das Funktionsschaltbild der neuen Schaltungsanordnung,
- Fig. 2: ein Ausführungsbeispiel der neuen Schaltungsanordnung,
- Fig. 3: Spannungsverläufe zwischen zwei Bezugspunkten des Ausführungsbeispiels,
- Fig. 4: den Spannungsverlauf am Ausgang des Ausführungsbeispiels während eines Austastimpulses.

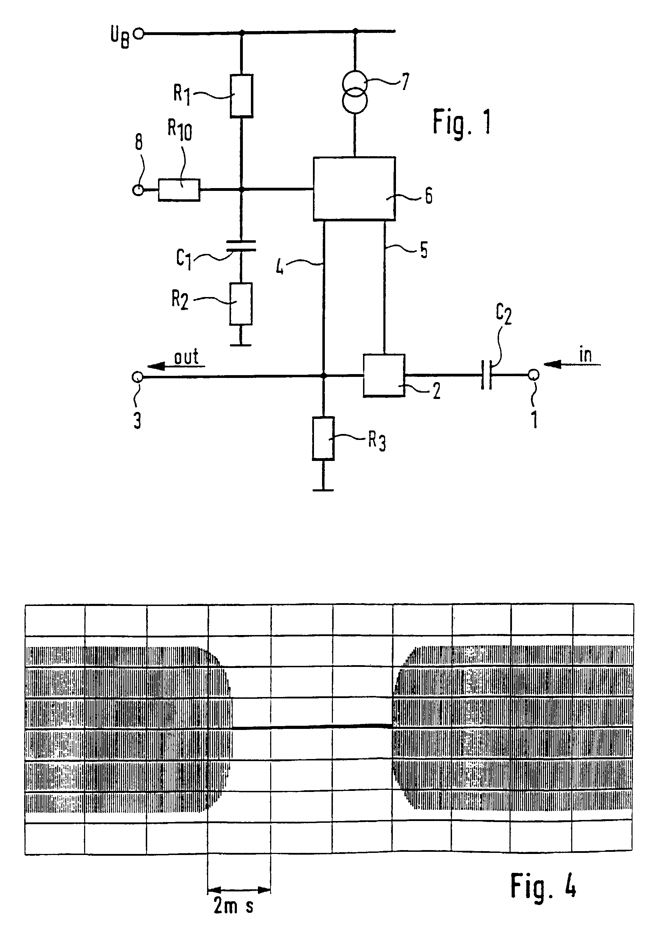

Das kurzzeitig zu unterbrechende niederfrequente Nutzsignal wird in Fig. 1 vom NF-Eingang 1 der Schaltungsanordnung über einen Koppelkondensator C₂ zu einer einen Unterbrecher 2 bildenden steuerbaren Halbleiterstrecke geführt. Der Ausgang des Unterbrechers 2, der über einen Widerstand R₃ an Masse liegt, bildet zugleich den NF-Ausgang 3 der Schaltungsanordnung.

Der Widerstand R₃ legt auch den DC-Arbeitspunkt des Unterbrechers 2 fest.

An den Ausgang des Unterbrechers 2, d. h. an den Hochpunkt des Widerstandes R₃, ist ein Stromzweig 4 angeschlossen, der von einem Ausgang eines Umschalters 6 gespeist wird. Der Stromkreis 4 liegt parallel zum Steuerkreis 5 des Unterbrechers 2, welcher an den anderen Ausgang des Umschalters 6 angeschlossen ist. Der Eingang des Umschalters 6 ist mit einer Konstantstromquelle 7 verbunden, die an der Klemme für die Versorgungsspannung U_{B} liegt.

Die Stellung des Umschalters 6 wird durch den Ladezustand des Kondensators C₁ bestimmt, der über einen Widerstand R₂ an Masse liegt und über einen Widerstand R₁ mit der Klemme für die Versorgungsspannung U_{B} verbunden ist. An Klemme 8 wird über den Widerstand R₁₀ dem Hochpunkt des Kondensators C₁ und dem Umschalter 6 der Austastimpuls zugeführt. Die Stellung des Schaltarms des Umschalters 6 bestimmt, ob der Strom aus der Konstantstromquelle 7 über die Steuerstrecke 5 des Unterbrechers 2 und den Widerstand R₃ oder über den Stromzweig 4 und wiederum den Widerstand R₃ nach Masse fließt. In beiden Fällen entsteht am Widerstand R₃ derselbe Spannungsabfall, so daß am NF-Ausgang 3 kein Unterschied festzustellen ist, ob das NF-Signal selbst gerade gleich Null ist oder ob der Unterbrecher 2 die Weiterleitung des NF-Signals verhindert. Infolge des gleichbleibenden Potentials am Hochpunkt des Widerstandes R₃ erfolgt auch keine Umladung des Koppelkondensators C₂ bei der Stummschaltung oder deren Aufhebung.

Somit entstehen in der Schaltungsanordnung keine Spannungsänderungen, die Ursache für Knackgeräusche in der an den Ausgang 3 der Schaltungsanordnung angeschlossenen, nicht näher dargestellten Schaltung sein könnten.

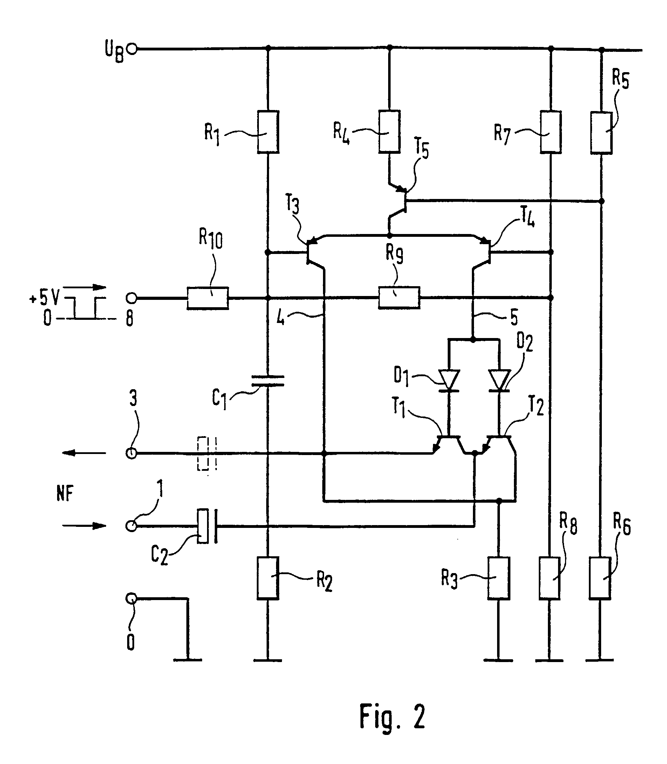

In dem in Fig. 2 dargestellten Ausführungsbeispiel der Schaltungsanordnung bilden zwei antiparallel geschaltete NPN-Transistoren T₁ und T₂ den erwähnten Unterbrecher 2. Die Basisanschlüsse der Transistoren T₁ und T₂, die im Steuerkreis 5 des Unterbrechers liegen, sind über ihnen zugeordnete Gleichrichter D₁ und D₂ mit dem einen Ausgang des Umschalters 6 verbunden.

Den Umschalter 6 bilden zwei parallel liegende PNP-Transistoren T₃ und T₄, die mit den an ihren Kollektoren angeschlossenen Stromzweigen 4 und 5 sowie dem Widerstand R₃ zu einer Differenzschaltung miteinander verbunden sind. An die Emitter der Transistoren T₃ und T₄ ist der Kollektor eines weiteren PNP-Transistors T₅ angeschlossen, der als Konstantstromquelle 7 dient und dessen Emitter über einen Widerstand R₄ an die Klemme für die Versorgungsspannung U_{B} von 8,5 V angeschlossen ist.

Ein Spannungsteiler aus den Widerständen R₅ und R₆ ist zwischen die Klemme U_{B} und Masse geschaltet und bestimmt den Arbeitspunkt des Transistors T₅. Der Basisanschluß des Transistors T₅ ist mit der Verbindungsleitung verbunden, die zwischen den Widerständen R₅ und R₆ angeordnet ist. Ein zweiter Spannungsteiler aus den Wider-ständen R₇ und R₈, der ebenfalls zwischen der Klemme U_{B} und Masse liegt, bestimmt den statischen Arbeitspunkt des Transistors T₄ in der Differenzschaltung.

Die an dem Abgriff des zweiten Spannungsteilers R₇, R₈ liegende Basis des Transistors T₄ ist weiterhin über einen Widerstand R₉ mit dem Hochpunkt des Kondensators C₁ verbunden. Auf dessen Potential liegt auch die Basis des Transistors T₃ in der Differenzschaltung. Dieses Potential wird einerseits über den Widerstand R₁₀ von der Spannung am Austastimpuls eingang 8 bestimmt, zum anderen vom Verhältnis der Widerstände R₁, R₂, von denen der Widerstand R₁ mit der Klemme U_{B} verbunden ist, während der Widerstand R₂ an Masse liegt.

Die Auslegung des Umschalters 6 als Differenzschaltung bewirkt eine gesteuerte Schaltgeschwindigkeit des Umschalters und damit eine gesteuerte Flankensteilheit der Unterbrechung des NF-Signals. Eine Unterbrechung mit entsprechend gesteuerter Flankensteilheit wiederum verkürzt den Zeitbedarf für den Abfall des NF-Signals bzw. dessen Wiederanstieg bei minimalem Störspektrum. Dadurch läßt sich eine Steuerfunktion vorgegebener Dauer während einer kürzeren Unterbrechung des NF-Signals durchführen, was die Vermeidung der Wahrnehmung der Unterbrechung deutlich verbessert.

Während der Dauer des Austastimpulses wird das Potential am Austastimpulseingang 8 von etwa 5,0 V auf 0 V abgesenkt. Die Angabe von Spannungswerten bei der nachfolgenden Beschreibung beruht auf der Verwendung von NPN-Transistoren des Typs BC 848 C als T₁ und T₂ und von PNP-Transistoren des Typs BC 858 C als T₃, T₄ und T₅.

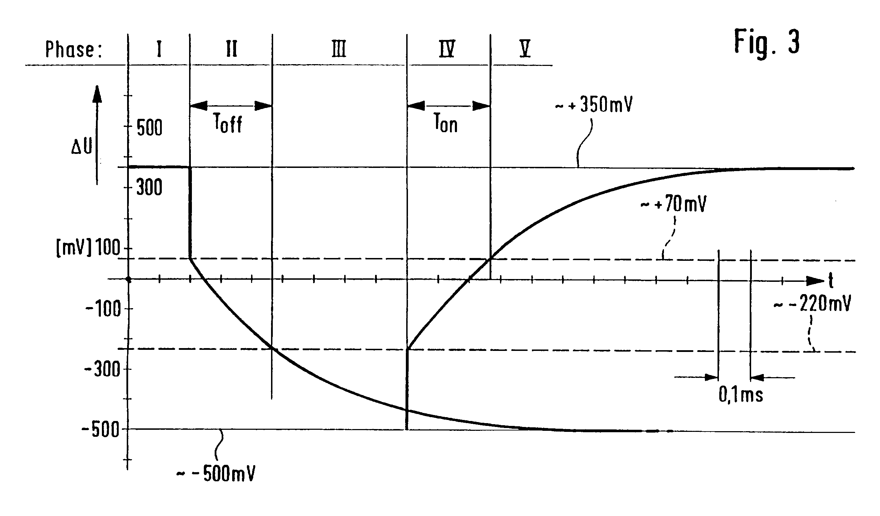

Die Fig. 3 zeigt links den Spannungsverlauf zwischen der Basis des Transistors T₃ und der Basis des Transistors T₄, der als Referenz dient, während der abfallenden Flanken, d. h. am Anfang eines Austastimpulses und rechts während der wieder ansteigenden Flanke, d. h. am Ende eines Austastimpulses. Während des Ruhezustandes der Austastleitung (Phase I) ist der Transistor T₃ gesperrt, und der Strom aus der Konstantstromquelle T₅ fließt voll über den Transistor T₄, dessen Basis zu dieser Zeit auf etwa 5,5 V liegt. Mit dem Beginn der abfallenden Flanke des Austastimpulses in der Schaltphase II fällt auch die Spannung zwischen den Steuerelektroden der beiden Transistoren T₃, T₄ des Differenzverstärkers sprunghaft von etwa + 350 mV auf etwa + 70 mV ab, wobei dieser Spannungswert im wesentlichen durch die Bemessung der Widerstände R₁, R₂ und R₉ bestimmt ist. Dann beginnt sich der Kondensator C₁ zu entladen, und das Potential an seinem Hochpunkt und damit an der Basis des Transistors T₃ sinkt weiter gegenüber dem Arbeitspunkt des Transistors T₄, zunächst etwa linear auf einen negativen Wert von etwa 220 mV. Mit der Entladung des Kondensators C₁ beginnt auch die Stromführung in den beiden Transistoren des Differenzverstärkers sich zu verändern. Ist der Spannungswert von - 220 mV erreicht, dann ist die Änderung der Stromführung in dem Differenzverstärker abgeschlossen, und der Strom fließt ausschließlich über den Transistor T₃.

Die Spannung am Hochpunkt des Kondensators C₁ fällt in der Phase III zwar langsam noch weiter bis auf etwa - 500 mV. Dieser weitere Abfall dient aber nur der Sicherheit der neuen Stromflußverteilung im Hinblick auf mögliche Transistordatenstreuungen. Die Überblendung von einer Stromführung durch den Transistor T₄ auf den Transistor T₃ selbst dauert etwa 0,3 ms.

Während der Überblendung nimmt die Leitfähigkeit der den Umschalter 2 bildenden Transistoren T₁ und T₂ etwa kosinusförmig ab, so daß sich der in Fig. 4 angedeutete Verlauf der NF-Signal-Amplituden am NF-Ausgang 3 zeigt, der ein geringes Störspektrum aufweist.

Am Ende der ersten Überblendung fließt der unverändert gebliebene Strom voll über den Transistor T₃ und von dessen Kollektor über den Widerstand R₃ nach Masse; d. h. der Widerstand R₃ wird ständig vom gleichen Strom durchflossen, so daß sich der von ihm bestimmte Arbeitspunkt des NF-Ausgangs 3 der Schaltungsanordnung während und nach der Überblendung nicht ändert und damit in der an den Ausgang 3 wechselstrommäßig angeschlossenen, nicht dargestellten Schaltung die Überblendung keine DC-Störungen verursacht.

Am Ende eines Austastimpulses, dessen Dauer in Fig. 3 mit 0,7 ms angenommen ist (in der Praxis etwa 8 ms), verursacht die wieder ansteigende Flanke des Austastimpulses zunächst in Phase IV einen Spannungssprung auf etwa - 220 mV und von dort ab infolge der Wiederaufladung des Kondensators C₁ einen fast linearen Anstieg auf etwa + 70 mV und danach in Phase V auf etwa + 350 mV in einem exponentiellen Verlauf. Auch am Ende des Schaltimpulses ändert sich also die Stromverteilung in dem Differenzverstärker, wobei dieses Mal die Überblendung auf die Stromführung durch den Transistor T₄ erfolgt.

Die Ausblendung der Stromführung durch den Transistor T₃ am Anfang eines Austastimpulses und die Wiedereinblendung am Ende eines Austastimpulses vermeidet auch eine Umladung des Kondensators C₂, so daß auch hierdurch keine nachteiligen Störeffekte verursacht werden. Die Längsauftrennung des Signals sorgt auch bei einem von außen aufgeprägten Umladungspotential von C₂ für störfreien Betrieb.

| **Legende** | |
|---|---|
| 1 = NF-Eingang | C₂ |
| 2 = Unterbrecher | T₁, T₂ |
| 3 = NF-Ausgang | R₃ |
| 4 = Stromzweig | |
| 5 = Steuerkreis des Unterbrechers | D₁, D₂ |
| 6 = Umschalter = Differenzschaltung | T₃, T₄ |
| 7 = Konstantstromquelle | T₅, R₄ |
| 8 = Austastimpulseingang | R₁₀ |

## Patentansprüche

1. Schaltungsanordnung zum kurzzeitigen Stummschalten der Wiedergabe eines NF-Signals in einem Rundfunkempfänger mit einem im NF-Signalweg angeordneten Unterbrecher (2), der während der Dauer eines der Schaltungsanordnung zugeführten (8) Austastimpulses eine Unterdrückung der NF-Signalwiedergabe an dem über einen Widerstand (R3) an Masse liegenden NF-Signalausgang (3) bewirkt und durch den Ladezustand eines mit dem Austastimpuls beaufschlagten Kondensators (C₁) gesteuert wird,
dadurch gekennzeichnet,
daß eine Steuerstrecke des Unterbrechers (2) einen Teil eines ersten Stromzweiges (5) bildet, daß parallel zum ersten Stromzweig (5) ein anderer zweiter Stromzweig (4) liegt, daß beide Stromzweige (4, 5) einerseits an den Widerstand (R₃) und andererseits an einen von einer Konstantstromquelle (7) gespeisten Umschalters (6) angeschlossen sind, daß ein Eingang des Umschalters (6) mit dem Kondensator (C₁) verbunden ist und daß die Stromverteilung auf den ersten und/oder zweiten Stromzweig (4, 5) im Umschalter (6) in Abhängigkeit vom Ladezustand des Kondensators (C₁) bestimmt ist.

2. Schaltungsanordnung nach Anspruch 1,
dadurch gekennzeichnet,
daß der Unterbrecher (2) aus zwei antiparallel geschalteten Transistoren (T₁, T₂) gleichen Leitungstyps aufgebaut ist.

3. Schaltungsanordnung nach Anspruch 2,
dadurch gekennzeichnet,
daß die Basisstrecken beider Transistoren (T₁ T₂) über parallel geschaltete Dioden (D₁, D₂) an den einen Eingang des Umschalters (6) angeschlossen sind.

4. Schaltungsanordnung nach Anspruch 1, 2 oder 3,
dadurch gekennzeichnet,
daß beide Transistoren (T₃, T₄) im Umschalter (6) mit den an ihren Kollektoren angeschlossenen Stromkreisen (4, 5, R₃) eine Differenzschaltung bilden, wobei die Basis des einen Transistors (T₄) über einen Widerstand, die Basis des anderen Transistors (T₃) direkt an den Hochpunkt des Kondensators (C₁) angeschlossen ist, und daß das Potential am Hochpunkt des Kondensators die Stromverteilung in der Differenzschaltung bestimmt.

5. Schaltungsanordnung nach Anspruch 4,
dadurch gekennzeichnet,
daß der Austastimpuls über einen Widerstand (R₁₀) an den Hochpunkt des Kondensators angelegt wird.

6. Schaltungsanordnung nach Anspruch 5,
dadurch gekennzeichnet,
daß der Hochpunkt des Kondensators (C₁) über einen Widerstand (R₁) an die Spannungsquelle (U_{B}) und der Tiefpunkt des Kondensators (C₁) über einen Widerstand (R₂) an Masse angeschlossen sind.

## Claims

1. Circuit arrangement for momentarily muting the reproduction of an AF signal in a radio receiver having an interrupter (2) which is arranged in the AF signal path, effects suppression of the AF signal reproduction at the AF signal output (3), which is connected to earth via a resistor (R3), for the duration of a blanking pulse fed (8) to the circuit arrangement and is controlled by the charge state of a capacitor (C₁) to which the blanking pulse is applied,
characterized
in that a control section of the interrupter (2) forms part of a first current path (5), in that another, second current path (4) is in parallel with the first current path (5), in that both current paths (4, 5) are connected on the one hand to the resistor (R₃) and on the other hand to a changeover switch (6) fed by a constant-current source (7), in that an input of the changeover switch (6) is connected to the capacitor (C₁), and in that the current distribution between the first and/or second current path (4, 5) is determined in the changeover switch (6) as a function of the charge state of the capacitor (C₁).

2. Circuit arrangement according to Claim 1,
characterized
in that the interrupter (2) is constructed from two transistors (T₁, T₂) of the same conduction type connected back-to-back.

3. Circuit arrangement according to Claim 2,
characterized
in that the base junctions of the two transistors (T₁, T₂) are connected to one input of the changeover switch (6) via diodes (D₁, D₂) connected in parallel.

4. Circuit arrangement according to Claim 1, 2 or 3,
characterized
in that the two transistors (T₃, T₄) in the changeover switch (6) form a differential circuit with the electric circuits (4, 5, R₃) connected to their collectors, the base of one transistor (T₄) being connected via a resistor and the base of the other transistor (T₃) being connected directly to the high point of the capacitor (C₁), and in that the potential at the high point of the capacitor determines the current distribution in the differential circuit.

5. Circuit arrangement according to Claim 4,
characterized
in that the blanking pulse is applied via a resistor (R₁₀) to the high point of the capacitor.

6. Circuit arrangement according to Claim 5,
characterized
in that the high point of the capacitor (C₁) is connected via a resistor (R₁) to the voltage source (U_{B}) and the low point of the capacitor (C₁) is connected via a resistor (R₂) to earth.

## Revendications

1. Circuit pour bloquer brièvement la reproduction d'un signal BF par un récepteur radio, comprenant un moyen de coupure (2) monté dans le chemin du signal BF, qui pendant la durée d'une impulsion de suppression appliquée à l'entrée (8) du circuit, bloque la reproduction du signal BF à la sortie (3) du signal BF reliée à la masse par l'intermédiaire d'une résistance (R₃), et qui commande l'état de charge d'un condensateur (C₁) recevant l'impulsion de suppression,
caractérisé en ce qu'
• un chemin de commande du moyen de coupure (2) constitue une partie d'une première branche de courant (5),
• une seconde branche de courant (4) est en parallèle à la première branche (5),
• les deux branches de courant (4, 5) sont reliées d'une part à la résistance (R₃) et d'autre part à un commutateur (6) alimenté par une source de courant constant (7),
• une entrée du commutateur (6) est reliée au condensateur (C₁) et,
• la répartition du courant entre la première et/ou la seconde branche de courant (4, 5) est définie dans le commutateur (6) en fonction de l'état de charge du condensateur (C₁).

2. Circuit selon la revendication 1,
caractérisé en ce que
le moyen de coupure (2) est formé de deux transistors (T₁, T₂) de même type de conductivité, en montage antiparallèle.

3. Circuit selon la revendication 2,
caractérisé en ce que
les chemins de base des deux transistors (T₁ T₂) sont reliés par des diodes (D_{1,}, D₂) en parallèle à une entrée du commutateur (6).

4. Circuit selon l'une quelconque des revendications 1, 2, 3,
caractérisé en ce que
• les deux transistors (T₃, T₄) du commutateur (6) forment un circuit de différence avec les circuits de courant (4, 5, R₃) reliés à leurs collecteurs,
• la base de l'un des transistors (T₄) étant reliée par une résistance au point haut du condensateur (C₁) et la base de l'autre transistor (T₃) y est reliée directement, et
• le potentiel au point haut du condensateur définit la répartition du courant le circuit de différence.

5. Circuit selon la revendication 4,
caractérisé en ce que
l'impulsion de suppression est appliquée au point haut du condensateur par l'intermédiaire d'une résistance (R₁₀).

6. Circuit selon la revendication 5,
caractérisé en ce que
le point haut du condensateur (C₁) est relié par une résistance (R₁) à la source de tension (U_{B}) et le point bas du condensateur (C₁) est relié à la masse par une résistance (R₂).
